(19) Europäisches Patentamt
European Patent Office
Office européen des brevets

(11) **EP 0 980 006 A2**

(12) **EUROPÄISCHE PATENTANMELDUNG**

(43) Veröffentlichungstag:
16.02.2000 Patentblatt 2000/07

(51) Int. Cl.[7]: **G01R 31/11**

(21) Anmeldenummer: **99115781.9**

(22) Anmeldetag: **10.08.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **13.08.1998 DE 19836826**

(71) Anmelder:
**SIEMENS AKTIENGESELLSCHAFT**
**80333 München (DE)**

(72) Erfinder:
• **Hillers, Thomas, Dipl.-Ing.**
**91058 Erlangen (DE)**
• **Korden, Christian, Dipl.-Ing.**
**80686 München (DE)**
• **Ostertag, Thomas, Dipl.-Ing.**
**85464 Finsing (DE)**

(54) **Verfahren zur Feststellung des Ortes eines Kurzschlusses in einer elektrischen Energieversorgungsleitung**

(57) Die Erfindung betrifft ein Verfahren zum Feststellen des Ortes eines Kurzschlusses in einer elektrischen Energieübertragungsleitung (1) mit zumindest einem in einer rohrförmigen, elektrisch leitfähigen Kapselung (5) geführten Innenleiter (2), bei dem ein durch den Kurzschluß beeinflußtes Störungssignal (15) mit einer Empfangseinrichtung (10) erfaßt und einer Auswerteeinrichtung (11) zugeführt wird. Um den Ort des Kurzschlusses (12) zu ermitteln, wird ein erstes Funksignal (13) in die Energieübertragungsleitung (1) gesendet, das am Ort (14) des Kurzschlusses reflektierte Funksignal als erstes Störungssignal (15) empfangen, in der Auswerteeinrichtung (11) eine Gesamtlaufzeit zwischen der Absendung des ersten Funksignals (13) und dem Empfang des ersten Störungssignals (15) ermittelt und mit der Gesamtlaufzeit ein erster Abstand des Ortes des Kurzschlusses (12) von einem Bezugsort (9) ermittelt.

FIG 1

EP 0 980 006 A2

**Beschreibung**

Die Erfindung betrifft ein Verfahren zum Feststellen des Ortes eines Kurzschlusses in einer elektrischen Energieübertragungsleitung mit zumindest einem in einer rohrförmigen, elektrisch leitfähigen Kapselung geführten Innenleiter, bei dem ein durch den Kurzschluß beeinflußtes Störungssignal mit einer Empfangseinrichtung erfaßt und einer Auswerteeinrichtung zugeführt wird.

Ein solches Verfahren ist aus der EP 0 793 112 A1 bekannt. Bei diesem Verfahren sind zur Ermittlung des Ortes eines Kurzschlusses in einer von einem Rohrleiter gebildeten elektrischen Energieübertragungsleitung entlang des Rohrleiters mehrere Erfassungseinrichtungen angeordnet. Diese sind zur Erfassung einer physikalischen Größe ausgelegt, die durch einen Kurzschluß beeinflußbar ist. Von den Erfassungseinrichtungen werden jeweils fortlaufend Meßwerte der Größe erfaßt und jeweils in einem zugeordneten Speicher abgelegt. Zusätzlich zu den Erfassungseinrichtungen ist ein Schutzgerät, insbesondere ein Distanzschutz vorgesehen, mit dem bei Auftreten eines Kurzschlusses ein betroffener Abschnitt der Energieübertragungsleitung ermittelt wird. Nach einem Auftreten eines Kurzschlusses erzeugt der Distanzschutz ein Ausgangssignal und zeigt den vom Kurzschluß betroffenen Leitungsabschnitt an. Zur Bestimmung des Ortes des Kurzschlusses innerhalb des betroffenen Leitungsabschnitts werden die gespeicherten Meßwerte der Erfassungseinrichtungen einer zentralen Auswerteeinrichtung zugeführt. Anhand dieser Meßwerte wird eine Laufzeitauswertung vorgenommen, mit der ein genauer Wert für den Ort des Kurzschlusses ermittelt wird.

Aus der DB 19 603 461 C2 ist ein Verfahren zur Stellungserfassung eines Schaltgeräts in einer gekapselten Schaltanlage bekannt. Dort wird ein Funksignal in den Innenraum der Kapselung gesendet und ein daraus resultierendes erstes Störungssignal empfangen und gespeichert. Danach wird ein zweites Funksignal in den Innenraum gesendet und ein daraus resultierendes zweites Störungssignal empfangen. Beide Störungssignale werden miteinander verglichen. Bei einer Abweichung der beiden Störungssignale voneinander wird davon ausgegangen, daß eine geometrische Änderung aufgrund einer Änderung des Schaltzustands innerhalb des Schaltgeräts erfolgt ist und es wird ein Meldesignal für die neue Schaltstellung des Schaltgeräts erzeugt.

Aufgabe der Erfindung ist es, ein Verfahren zur kostengünstigen und schnellen Ortung eines in einer Energieversorgungsleitung auftretenden Kurzschlusses anzugeben.

Gelöst wird diese Aufgabe bei einem Verfahren nach dem Oberbegriff des Patentanspruchs 1 erfindungsgemäß dadurch, daß

- ein erstes Funksignal in die Energieübertragungsleitung gesendet wird;

- das am Ort des Kurzschlusses reflektierte erste Funksignal erstes als Störungssignal empfangen wird,

- in der Auswerteeinrichtung eine Gesamtlaufzeit zwischen der Absendung des ersten Funksignals und dem Empfang des Störungssignals ermittelt wird und

- mit der Gesamtlaufzeit ein erster Abstand des Ortes des Kurzschlusses von einem Bezugsort ermittelt wird.

Es ist zwar aus der DE-0S 52 47 394 ein Verfahren zur Feststellung des Reflexionsfaktors von Störstellen in Leitungen/Hohlkabeln, insbesondere sogenannten $H_{01}$-Wellenleitern, bekannt, die jedoch für die hochfrequente Datenübertragung innerhalb von Nachrichtennetzen bekannt sind. Anhand des Verfahrens sollen sogenannte Störstellen im Hohlkabel untersucht werden. Dabei wird anhand einer bekannten Referenzstörstelle der zunächst unbekannte Reflexionsfaktor einer nach der Impuls-Echomethode georteten Störstelle ermittelt.

Aus der US 4,316,139 A1 ist ferner ein Verfahren zur Lokalisierung eines Lichtbogens bekannt, bei dem an einem Meßort das Stehwellenverhältnis der sich ausbreitenden elektromagnetischen Welle gemessen wird. An dem Meßort wird mittels eines Vibrations-Sensors eine mechanische Vibration des Wellenleiters erfaßt. Durch einen Lichtbogen wird ein hohes Stehwellenverhältnis bewirkt und der Wellenleiter zu mechanischen Vibrationen angeregt, die sich entlang des Wellenleiters ausbreiten. Bedingt durch die geringe Fortpflanzungsgeschwindigkeit der Vibration entlang des Wellenleiters ist die Zeit zwischen dem Auftreten des Lichtbogens und dem Eintreffen der dadurch verursachten Vibration am Meßort lang. Der Ort des Lichtbogens kann also erst nach dieser langen Zeit ermittelt werden.

Mit dem erfindungsgemäßen Verfahren ist eine schnelle und genaue Ortung des Kurzschlusses möglich, da lediglich eine Auswertung des Störungssignals und des Funksignals erforderlich sind. Ein weiterer Vorteil besteht darin, daß der Aufwand für das Durchführen des erfindungsgemäßen Verfahrens vergleichsweise gering ist, weil es nur einer Sende-, einer Empfangs- und einer Auswerteeinrichtung bedarf.

Bevorzugtermaßen werden bei dem erfindungsgemäßen Verfahren ein Frequenzunterschied zwischen dem ersten Störungssignal und dem ersten Funksignal ermittelt und bei Vorliegen eines Unterschiedes auf einen Kurzschluß mit Lichtbogen erkannt. Bei dem Verfahren wird der bei einer Reflexion an bewegten Objekten auftretende Dopplereffekt ausgenutzt. Anhand des Frequenzunterschiedes ist leicht erkennbar, ob sich der Kurzschluß bewegt hat, was ein sicheres Indiz dafür ist, daß ein Lichtbogen den Kurzschluß verursacht hat.

Vorzugsweise wird das Verfahren mit folgenden Schritten durchgeführt:

- ein zweites Funksignal wird zeitlich nach dem ersten Funksignal in die Energieübertragungsleitung gesendet,
- das am Ort des Kurzschlusses reflektierte zweite Funksignal wird als zweites Störungssignal empfangen,
- in der Auswerteeinrichtung wird eine zweite Gesamtlaufzeit zwischen der Absendung des zweiten Funksignals und dem Empfang des zweiten Störungssignals ermittelt,
- mit der zweiten Gesamtlaufzeit wird ein zweiter Abstand des Ortes des Kurzschlusses ermittelt,
- ein Unterschied zwischen dem ersten und dem zweiten Abstand wird ermittelt und
- bei Vorliegen eines Unterschiedes wird auf einen Kurzschluß mit Lichtbogen erkannt.

Anhand des Unterschiedes zwischen dem ersten und dem zweiten Abstand ist einfach feststellbar, ob sich der Kurzschluß bewegt hat, so daß hier auf einfache Weise der Lichtbogen erkannt wird. Der Unterschied zwischen dem ersten und dem zweiten Abstand ist mit sehr viel geringem Aufwand ermittelbar, als ein Frequenzunterschied. Die Ermittlung des Unterschiedes zwischen dem ersten und dem zweiten Abstand ist also ein einfacher, schnell durchzuführender Schritt, um eine Bewegung zu erkennen und damit auf einen Lichtbogen zu schließen.

Bei dem Verfahren wird vorzugsweise mit dem ersten und dem zweiten Abstand ein Leitungsabschnitt ermittelt, in dem sich der Kurzschluß bewegt hat. Dadurch läßt sich genau angeben, in welchem Leitungsabschnitt der Lichtbogen möglicherweise eine Beschädigung verursacht hat. Zur ggf. erforderlichen Reparatur ist dann genau bekannt, zu welchem Leitungsabschnitt ein Zugang geschaffen werden muß. Der Leitungsabschnitt ist mit dem ersten Abstand und mit dem Unterschied sehr genau ermittelbar.

Bevorzugterweise wird das Verfahren mit folgenden Schritten durchgeführt:

- als erstes Funksignal wird ein erster Funkimpuls verwendet,
- der am Ort des Kurzschlusses reflektierte erste Funkimpuls wird als erstes Störungssignal empfangen,
- als ein zweites Funksignal wird ein zweiter Funkimpuls verwendet, der in die Energieübertragungsleitung gesendet wird,
- der am Ort des Kurzschlusses reflektierte zweite Funkimpuls wird als zweites Störungssignal empfangen
- eine erste Störungssignalphase des ersten Störungssignals zum ersten Funkimpuls wird ermittelt,
- eine zweite Störungssignalphase des zweiten Störungssignals zum zweiten Funkimpuls wird ermittelt und
- bei Vorliegen eines Unterschiedes zwischen der ersten Störungssignalphase und der zweiten Störungssignalphase wird auf einen Kurzschluß mit Lichtbogen erkannt.

Die Ermittlung des Unterschiedes zwischen der ersten Störungssignalphase und der zweiten Störungssignalphase ist eine weitere Möglichkeit, auf eine Bewegung des Kurzschlusses und damit auf einen Lichtbogen zu erkennen. Die beiden Funktastsignale werden in einem so kurzen zeitlichen Abstand gesendet, daß die Bewegung des Lichtbogens nur zu einem Unterschied von kleiner 360° zwischen der ersten Störungssignalphase und der zweiten Störungssignalphase führt. Dadurch ist eine Mehrdeutigkeit im Unterschied der Signalphasen vermieden. Die Genauigkeit der Ortung steigt hierbei mit steigender Frequenz des gesendeten Funksignals an.

Bevorzugt wird mit dem Unterschied zwischen der ersten Störungssignalphase und der zweiten Störungssignalphase ein Leitungsabschnitt ermittelt, in dem sich der Lichtbogen bewegt hat.

Vorzugsweise werden der erste Funkimpuls und der zweite Funkimpuls durch Tastung eines periodischen Trägersignals gewonnen. Dadurch sind die Funkimpulse auf einfache Weise mit gleichem Zeitverlauf erzeugbar.

Bevorzugt sind das Funksignal bzw. die Funksignale so bandbegrenzt, daß nur der Grundmode der Energieübertragungsleitung angeregt wird. Durch die alleinige Anregung des Grundmodes ist vermieden, daß das Funksignal oder die Funksignale bei der Übertragung in der Energieversorgungsleitung verzerrt werden (Modensispersion). Eine elektromagnetischen Welle kann sich in einer gekapselten elektrischen Leitung in verschiedenen Arten von Moden, nämlich im Grundmode und/oder in höheren Ausbreitungsmoden ausbreiten. Eine charakteristische Größe jedes Modes ist seine ihm eigene sogenannte cut-off-Frequenz. Die cut-off-Frequenz eines Modes gibt an, welche minimale Frequenz ein spektraler Anteil eines Signals aufweisen muß, um den Mode anzuregen. Der Grundmode weist die niedrigste cut-off-Frequenz $fcG$ auf. Der nächsthöhere Ausbreitungsmode weist die zweitniedrigste cut-off-Frequenz $fcG1$ auf. In den verschiedenen Moden kann sich die elekromagnetische Welle mit unterschiedlichen Ausbreitungsgeschwindigkeiten fortpflanzen. Dies führt dazu, daß einzelne Signalanteile, die gemeinsam das Funksignal bilden, unterschiedlich schnell übertragen werden. Dadurch wird das Funksignal verzerrt und eine genaue Ortung wird erschwert. Um nur den Grundmode anzuregen, sind das Funksignal oder die Funksignale so bandbegrenzt, daß es/sie nur spektrale Anteile enthält/enthalten, deren Frequenzen kleiner sind, als die cut-off-Frequenz $fch1$ des nächsthöheren Ausbreitungsmodes. Beispielsweise kann die Pulsform des Funksignals dazu im wesentlichen gaußförmig, entsprechend der Gauß'schen Glokkenkurvenform, sein.

Je geringer die Pulsbreite des Funksignals ist, um so genauer kann der Ort der Störung erfaßt werden, allerdings steigt mit geringer werdender Pulsbreite die Bandbreite des Funksignals an. Um beiden Erfordernissen ausreichend gerecht zu werden, weist das Funksignal bevorzugt eine Pulsbreite zwischen 20 ns und 50 n, insbesondere 33 ms auf. Mit der Pulsbreite von 33 n wird weitgehend nur der Grundmode (TEM-Mode) der Energieversorgungsleitung angeregt und gleichzeitig der Ort der Störung mit der hohen Genauigkeit von ± 5 m bei einer Ausbreitungsgeschwindigkeit des Funksignals im Zwischenraum von $2,998 \times 10^8$ m/s ermittelbar. Für eine genauere Ortsauflösung, beispielsweise ± 1 m, ist die Pulsbreite entsprechend anzupassen.

Vorzugsweise werden die Funksignale mit einem zeitlichen Abstand nacheinander gesendet, der größer ist als das Verhältnis von der zweifachen Länge der Energieübertragungsleitung zur Ausbreitungsgeschwindigkeit eines Funksignals in der Energieübertragungsleitung. Der zeitliche Abstand ist so gewählt, daß jedes Störungssignal jeweils seinem verursachenden Funksignal eindeutig zugeordnet werden kann. Gleichzeitig ist der zeitliche Abstand zweier aufeinanderfolgender Funksignale noch so kurz, daß eine schnelle Erkennung einer plötzlich auftretenden Störung möglich ist.

Bevorzugt wird bei einer Länge von 10 km und einer Ausbreitungsgeschwindigkeit von $2,998 \cdot 10^8$ m/s ein zeitlicher Abstand zwischen 0,1 ms und 0,067 ms verwendet. Dadurch ist das Verfahren bei einer Leitung mit einer Länge von 10 km und einer Ausbreitungsgeschwindigkeit von unter Gewährleistung der eindeutigen Zuordnung jedes Störungssignals zu seinem verursachenden Funksignal anwendbar.

Bevorzugterweise wird von der Auswerteeinrichtung bei Vorliegen

- eines Frequenzunterschieds zwischen dem ersten Störungssignal und dem ersten Funksignal oder
- eines Unterschieds zwischen dem ersten Abstand und dem zweiten Abstand oder
- eines Unterschieds zwischen der ersten Störungssignalphase und der zweiten Störungssignalphase

ein einen Kurzschluß mit Lichtbogen anzeigendes Kennsignal gebildet. Mit dem Kennsignal wird das Auftreten eines Lichtbogens angezeigt. Bei der Bildung des Kennsignals läßt sich beispielsweise durch Vorgabe eines Schwellwerts sicherstellen, daß nur eine tatsächlich erfolgte Bewegung angezeigt wird und nicht durch evtl. vorliegende Störungen der Signale fälschlicherweise eine Bewegung des Kurzschlusses erkannt wird.

Bei Anwendung des Verfahrens können durch ein einziges Funksignal verursacht mehrere jeweils durch Reflexion hervorgerufene Störungssignale auftreten, da die Energieübertragungsleitung Unregelmäßigkeiten aufweist, die Reflexionen verursachen können. Anhand der oben aufgeführten auf eine Bewegung hinweisenden Unterschiede kann leicht das Störungssignal bzw. die Störungssignale identifiziert werden, das/die an einem Lichtbogen reflektiert wurde/n. Der gesuchte Abstand des Ortes des Kurzschlusses vom Bezugsort ist dann der Abstand, der mit dem zuletzt so identifizierten Störungssignal ermittelt wurde.

Das Verfahren wird bevorzugt gleichzeitig mit einem anderen Meßverfahren an der Energieübertragungsleitung durchgeführt, wobei eine Kurzschlußmessung erfolgt und im Störungsfall eine Energiezufuhr zur Energieübertragungsleitung unterbrochen wird. Durch die gleichzeitige oder parallele Anwendung des Verfahrens ist nicht nur die Energiezufuhr zur Energieübertragungsleitung unterbrechbar, um eine Beschädigung durch den Kurzschluß zu vermeiden, sondern es ist zusätzlich der Ort des Kurzschlusses und gegebenenfalls ein Leitungsabschnitt ermittelbar, in dem sich ein Kurzschluß mit Lichtbogen bewegt hat.

Vorzugsweise wird mit dem Funksignal ein in der Energieübertragungsleitung angeordneter drahtlos abfragbarer Sensor abgefragt. Das Funksignal kann also gleichzeitig zur Ortung des Kurzschlusses und zur Abfrage eines solchen Sensors verwendet werden. Solche Sensoren sind in beispielsweise aus der DE 19 603 461 bekannt.

Anhand der Zeichnung ist nachfolgend eine die Vorrichtung und ein das erfindungsgemäße Verfahren zum Feststellen des Ortes eines Kurzschlusses in einer elektrischen Leitung beispielhaft näher erläutert. Es zeigen:

Figur 1 einen Abschnitt einer elektrischen Energieübertragungsleitung,
Figur 2 ein erstes Zeitdiagramm der Signale,
Figur 3 ein weiteres Zeitdiagramm und
Figur 4 ein drittes Zeitdiagramm.

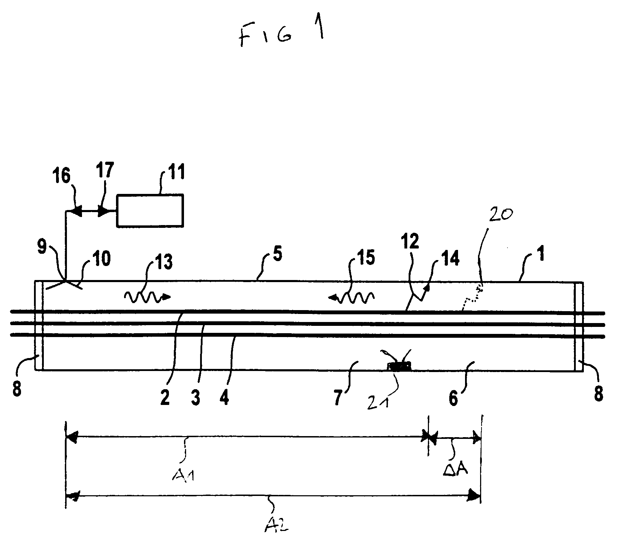

In der Figur 1 ist ein Abschnitt einer elektrischen Energieübertragungsleitung 1, die als elektrische Hochspannungs-Rohrleitung ausgeführt ist, dargestellt. Die elektrische Energieübertragungsleitung 1 weist drei Innenleiter 2 bis 4 auf, die von einer elektrisch leitfähigen Kapselung 5 umgeben sind, wodurch ein dreiphasiges Leitersystem gebildet ist. Zwischen der Kapselung 5 und den Innenleitern 2 bis 4 ist ein Zwischenraum 6 gebildet, der mit einem elektrisch isolierenden Gas 7 gefüllt ist. Die Innenleiter 2 bis 4 sind mit Isolationselementen 8 gegenüber der Kapselung 5 abgestützt. Die Energieübertragungsleitung 1 kann selbstverständlich auch mit einer anderen Anzahl von Innenleitern, insbesondere mit einem einzigen Innenleiter für einen einphasigen Betrieb, ausgeführt sein.

An einem am Ende der Kapselung 5 befindlichen Bezugsort 9 ist eine Sende- und Empfangseinrichtung mit einer Antenne 10 angeordnet, die mit einer Auswerteeinrichtung 11 verbunden ist. Die Antenne 10 ist auf den Zwischenraum 6 gerichtet.

Zur Ortung eines Kurzschlusses, insbesondere eines Lichtbogens 12, wird mit der Sende- und Empfangseinrichtung ein erstes Funksignal 13 in den Zwischenraum 6 gesendet, das am Ort 14 des Lichtbogens 12 zumindest teilweise als erstes Störungssignal 15 reflektiert wird und durch den Zwischenraum 6 zurück zur Sende-Empfangseinrichtung gelangt und dort empfangen wird. Das erste Funksignal 13 und das erste Störungssignal 15 werden als elektrische Signale 16 und 17 zwischen der Antenne 10 und der Auswerteeinrichtung 11 übertragen.

In der Auswerteeinrichtung 11 wird der Ort 14 des Kurzschlusses 12 und auch eine mögliche Bewegung des Kurzschlusses 12 ermittelt. Dazu wird die Gesamtlaufzeit $\Delta t1$ zwischen dem Absenden des ersten Funksignals 13 und dem Empfangen des ersten -Störungssignals 15 am Bezugsort 9 ermittelt, mit der der Abstand A1 zwischen dem Ort 14 und dem Bezugsort 9 unter Berücksichtigung der Ausbreitungsgeschwindigkeit v der Signale 13 und 15 in der Energieübertragungsleitung 1 berechnet wird. Weiterhin ist ein Frequenzunterschied zwischen dem ersten Funksignal 13 und dem ersten Störungssignal 15 zur Erkennung einer Bewegung des Kurzschlusses auswertbar. Dazu kann beispielsweise anhand der Frequenzspektren der Signale 13 und 15 ermittelt werden, ob sich deren Mittenfrequenzen unterscheiden. Das Vorliegen eines Frequenzunterschieds ist ein sicheres Indiz für einen durch Lichtbogen 12 verursachten Kurzschluß.

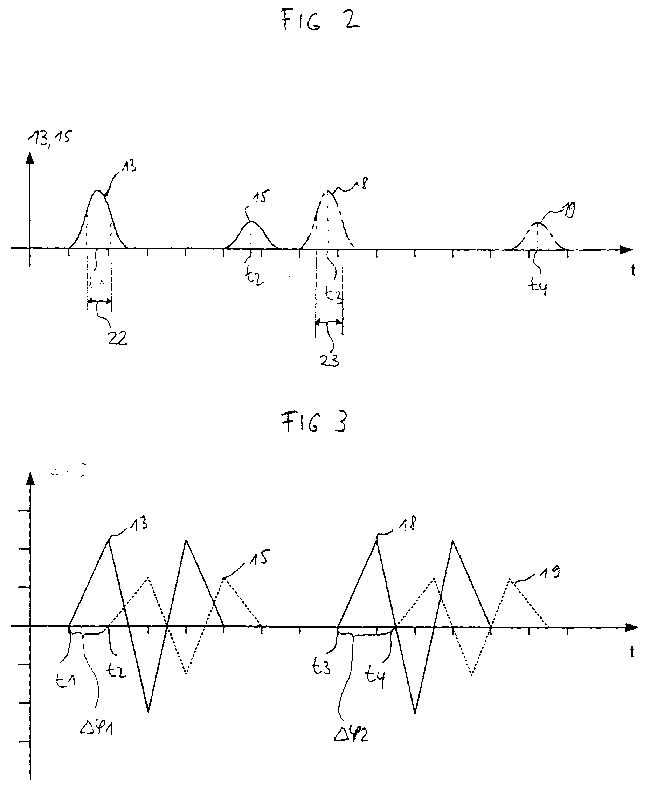

Des weiteren kann bei einer nachfolgenden Wiederholung des Verfahrens mit einem zweiten Funksignal 18 (siehe Figur 2) und einem zweiten Störungssignal 19 beispielsweise eine zweite Gesamtlaufzeit $\Delta t2$ ermittelt werden. Ein Unterschied zwischen der ersten Gesamtlaufzeit $\Delta t1$ und der zweiten Gesamtlaufzeit $\Delta t2$ weist dann ebenfalls auf eine erfolgte Bewegung des Kurzschlusses zu einem Ort 20 und damit auf den Lichtbogen 12 hin. Mit gepunkteten Linien ist der nach der Bewegung am Ort 20 befindliche Lichtbogen 12 angedeutet. Bei der Wiederholung kann auch ein zweiter Abstand A2 ermittelt werden, so daß aus dem ersten Abstand A1 und dem zweiten Abstand A2 ein Leitungsabschnitt $\Delta A$ ermittelt werden kann, innerhalb dessen sich der Lichtbogen 12 bewegt hat.

Von der Auswerteeinrichtung 11 ist außerdem ein Kennsignal erzeugbar, wenn eine Bewegung des Lichtbogens 12 ermittelt wurde. Dieses Kennsignal kann der Anzeige einer Bewegung des Lichtbogens 12 dienen. Anhand des Kennsignals können ggf. Schutzmaßnahmen ausgelöst werden.

Das Funksignal 13 dient hier auch gleichzeitig zur Abfrage eines drahtlos abfragbaren Sensors 21, insbesondere eines Oberflächenwellensensors. Ein solcher abfragbarer Sensor 21 ist beispielsweise in der oben genannten DE 19 603 461 beschrieben.

Die Energieübertragungsleitungsleitung 1 kann auch während des Betriebs gleichzeitig mit einem anderen Schutzverfahren auf ein Kurzschluß 12 überwacht werden. Dabei kann beispielsweise mit einer nicht näher dargestellten Schutzeinrichtung eine Kurzschlußmessung durchgeführt und im Störungsfall, d. h. bei Auftreten eines Kurzschlusses, die Energiezufuhr zur Energieübertragungsleitung 1 unterbrochen werden.

In Figur 2 ist ein Zeitdiagramm der Funksignale 13 und 18 sowie der Störungssignale 15 und 19 dargestellt. Zu einem Zeitpunkt t1 wird das erste Funksignal 13 von der Sende- und Empfangseinrichtung 10 gesendet. Wie schon zuvor erläutert, wird das erste Funksignal 13 am Ort 14 des Lichtbogens 12 reflektiert und als erstes Störungssignal 15 wieder von der Antenne 10 zu einem Zeitpunkt t2 empfangen. Damit ergibt sich die Gesamtlaufzeit zwischen dem Absenden des ersten Funksignals 13 und dem Empfang des ersten Störungssignals 15 zu $\Delta t1 = t2 - t1$. Mit dieser Gesamtlaufzeit $\Delta t1$ und der Ausbreitungsgeschwindigkeit v kann der Abstand A1 des Ortes 14 vom Bezugsort 9 berechnet werden.

Nach dem Empfang des ersten Störungssignals 15 kann, wie mit strichpunktierten Linien angedeutet, das zweite Funksignal 18 zum Zeitpunkt t3 über die mittels der Antenne 10 in die Energieübertragungsleitung 1 gesendet werden. Ist der Lichtbogen 12 noch vorhanden, so wird auch das zweite Funksignal 18 reflektiert und als zweites Störungssignal 19 am Bezugsort 9 zu einem Zeitpunkt t4 empfangen. Die zweite Gesamtlaufzeit $\Delta t2$ zwischen dem Zeitpunkt t3 und dem Zeitpunkt t4 ergibt sich dann zu $\Delta t2 = t4 - t3$. Mit dieser zweiten Gesamtlaufzeit $\Delta t2$ läßt sich ein zweiter Abstand A2 (siehe Figur 1) ermitteln. Sind die Gesamtlaufzeiten $\Delta t1$ und $\Delta t2$ und damit auch die Abstände A1 und A2 verschieden, so hat sich der Lichtbogen 12 bewegt. In Figur 1 ist der Fall dargestellt, daß die Gesamtlaufzeit $\Delta t2$ gegenüber $\Delta t1$ größer ist und damit auch der Abstand 12 größer als der Abstand A1 ist, so daß sich der Lichtbogen 12 vom Ort 14 zum Ort 20 bewegt und damit von Bezugsort 9 entfernt hat. Anhand der Differenz vom Abstand A2 zum Abstand A1 bzw. der Differenz der Gesamtlaufzeit $\Delta t2$ zur Gesamtlaufzeit $\Delta t1$ kann aber auch also auch bestimmt werden, in welche Richtung sich der Lichtbogen 12 in der elektrischen Energieversorgungsleitung 1 bewegt hat.

Das erste Funksignal 13 und das zweite Funksignal 18 weisen jeweils eine gaußförmige Pulsform und dadurch ein begrenztes Frequenzspektrum und eine begrenzte Brandbreite auf. Die Pulsbreite 22 des ersten Funksignals 13 und die Pulsbreite 23 des zweiten Funksignals 18 sind in einem Bereich von 20 ns - 50 ns speziell zu 33 ns gewählt. Die Pulsbreiten 22 und 23 bestimmen die Auflösung bei der Ortung des Lichtbogens 12. Mit einer Pulsbreite von beispielsweise 33 ns ist eine Ortung des Lichtbogens 12 mit einer Auflösung von $\pm$ 5 m bei einer Ausbreitungsgeschwindigkeit der Signale 13, 15 im Zwischenraum 6 von $2,998 \times 10^8$ m/s

möglich. Für andere Auflösungen ist die Pulsbreite entsprechend anzupassen.

Bei dem Verfahren wird das zweite Funksignal 18 erst dann gesendet, wenn das erste Störungssignal 15 empfangen ist. Dadurch ist vermieden, daß das erste Störungssignal 15 nicht mehr dem ersten Funksignal 13 zugeordnet werden kann. Dazu ist der zeitliche Abstand zwischen dem Zeitpunkt t1 des Aussendens des ersten Funksignals 13 und dem Zeitpunkt t3 des Aussendens des zweiten Funksignals 18 so gewählt, daß er größer ist als das Verhältnis von der zweifachen Länge der Energieübertragungsleitung zur Ausbreitungsgeschwindigkeit der Funksignale 13 bzw. 18. Bei einer Länge von 10 km und einer Ausbreitungsgeschwindigkeit von 2,9 $\cdot$ $10^8$m/s wird hierzu ein zeitlicher Abstand zwischen 0,1 ms und 0,067 ms verwendet.

In Figur 3 ist ein weiteres Zeitdiagramm mit den Funksignalen 13 und 18 und den Störungssignalen 15 und 19 dargestellt, die andere Zeitverläufe haben. Hier wird als erstes Funksignal 13 ein erster Funkimpuls gesendet und das am Ort des Kurzschlusses reflektierte erste Störungssignal 15 empfangen. Noch während des Aussendens des ersten Funksignals 13 wird das erste Störungssignal 15 empfangen. Dieser Fall tritt ein, wenn der Lichtbogen 12 sehr nahe am Bezugsort 9 auftritt. Neben der Gesamtlaufzeit wird auch die Störungssignalphase $\Delta\varphi 1$ ermittelt, die die Phasenverschiebung des Störungssignals 15 zum ersten Funksignal darstellt. Mit der Störungssignalphase $\Delta\varphi 1$ kann auch der Abstand A1 berechnet wrden. Wie zuvor schon dargestellt, wird auch hier nach dem Empfang des ersten Störungssignals 15 ein zweiter Funkimpuls als zweites Funksignal 18 gesendet und dadurch verursacht, das zweite Störungssignal 19 empfangen. Bei einem Unterschied der beiden Störungssignalphasen $\Delta\varphi 2$ wird eine Bewegung und damit ein Kurzschluß 12 mit Lichtbogen 12 erkannt. Mit der Differenz der Störungssignalphase $\Delta\varphi 2$ und $\Delta\varphi 1$ kann unter Berücksichtigung des Abstands A1 der Leitungsabschnitt $\Delta$A bestimmt werden, in dem sich der Lichtbogen bewegt hat.

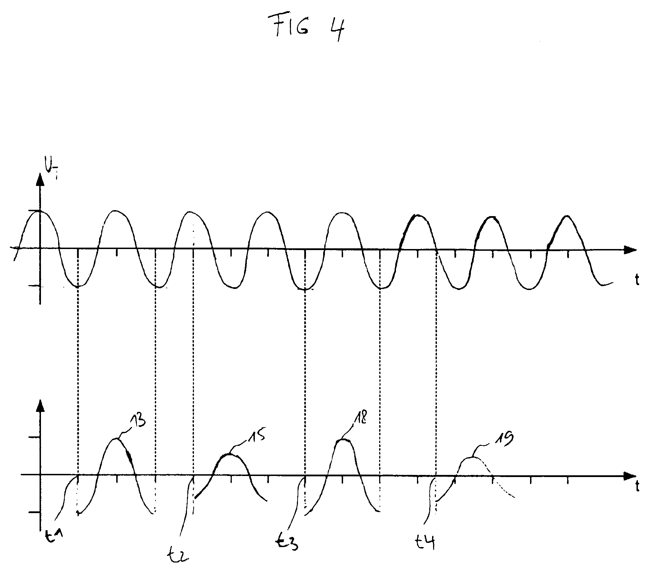

In Figur 4 sind zwei zusammengehörige Zeitdiagramme dargestellt. Das obere Zeitdiagramm zeigt ein periodisches Trägersignal UT. Im unteren Zeitdiagramm sind ein erstes durch Austastung aus dem Trägersignal UT gewonnenes Funksignal 13 und ein zweites durch Austastung aus dem periodischen Trägersignal UT gewonnenes Funksignal 18 dargestellt. Die beiden Funksignale 13 und 18 werden zu den Zeitpunkten t1 bzw. t3 ausgesendet. Die Funksignale 13 und 18 sind so aus dem Trägersignal UT ausgetastet, daß sie von ihrem jeweiligen Aussendezeitpunkt t1 bzw. t3 an einen gleichen zeitlichen Verlauf haben. Zu den Zeitpunkten t2 und t4 werden das an der Störung 12 reflektierte erste Störungssignal 15 und das zweite Störungssignal 19 empfangen. Anstelle der Ermittlung der Gesamtlaufzeiten $\Delta$t1 und $\Delta$t2 zur Bestimmung der

Abstände A1 bzw. A2 ist es hier auch möglich, das erste Störungssignal 15 und das zweite Störungssignal 19 jeweils bezüglich ihrer Phasendifferenz zum Trägersignal UT zu prüfen. Das erste Störungssignal 15 weist eine Störungssignalphase $\Delta\varphi 3$ von 180° zum Trägersignal UT auf. Das zweite Störungssignal 19 weist eine Störungssignalphase $\Delta\varphi 4$ von 270° zum Trägersignal auf. Anhand des Unterschiedes der Störungssignalphasen $\Delta\varphi 3$ und $\Delta\varphi 4$ kann wieder auf eine Bewegung des Lichtbogens 12 geschlossen werden. Hierbei ist allerdings Voraussetzung, daß der zeitliche Abstand zwischen den Aussendezeitpunkten t1 und t3 des ersten Funksignals 13 bzw. des zweiten Funksignals 18 so kurz gewählt ist, daß die Differenz zwischen den Störungssignalphasen $\Delta\varphi 4$ und $\Delta\varphi 3$ nicht größer als 360° wird. Andernfalls würde diese Differenz mehrdeutig und es könnte der Fall eintreten, daß das erste Störungssignal 15 und das zweite Störungssignal 19 gleiche Störungssignalphasen $\Delta\varphi 3$ bzw. $\Delta\varphi 4$ aufweisen, obwohl sich der Lichtbogen 12 bewegt hat und die Gesamtlaufzeiten $\Delta$t1 bzw. $\Delta$t2 unterschiedlich sind. Ist der Abstand A1 ermittelt worden, so kann mit der Differenz zwischen den Störungssignalphasen $\Delta\varphi 4$ und $\Delta\varphi 3$ der zweite Abstand A2 und damit auch der Leitungsabschnitt $\Delta$A ermittelt werden, indem sich der Lichtbogen bewegt hat.

## Patentansprüche

**1.** Verfahren zum Feststellen des Ortes eines Kurzschlusses in einer elektrischen Energieübertragungsleitung (1) mit zumindest einem in einer rohrförmigen, elektrisch leitfähigen Kapselung (5) geführten Innenleiter (2), bei dem ein durch den Kurzschluß beeinflußtes Störungssignal (15) mit einer Empfangseinrichtung (10) erfaßt und einer Auswerteeinrichtung (11) zugeführt wird,
**gekennzeichnet durch**
folgende Schritte:

- ein erstes Funksignal (13) wird in die Energieübertragungsleitung (1) gesendet,
- das am Ort (14) des Kurzschlusses reflektierte Funksignal wird als erstes Störungssignal (15) empfangen,
- in der Auswerteeinrichtung (11) wird eine Gesamtlaufzeit zwischen der Absendung des ersten Funksignals (13) und dem Empfang des ersten Störungssignals (15) ermittelt und
- mit der Gesamtlaufzeit wird ein erster Abstand des Ortes des Kurzschlusses (12) von einem Bezugsort (9) ermittelt.

**2.** Verfahren nach Anspruch 1,
**gekennzeichnet durch**
folgende Schritte:

- ein Frequenzunterschied zwischen dem ersten Störungssignal (15) und dem ersten Funksignal (13) wird ermittelt und

- bei Vorliegen eines Unterschiedes wird auf einen Kurzschluß mit Lichtbogen erkannt.

3. Verfahren nach Anspruch 1,
   **gekennzeichnet durch**
   folgende Schritte:

   - ein zweites Funksignal wird zeitlich nach dem ersten Funksignal in die Energieübertragungsleitung (1) gesendet,
   - das am Ort (14) des Kurzschlusses (12) reflektierte zweite Funksignal wird als zweites Störungssignal empfangen,
   - in der Auswerteeinrichtung (11) wird eine zweite Gesamtlaufzeit zwischen der Absendung des zweiten Funksignals und dem Empfang des zweiten Störungssignals ermittelt,
   - mit der zweiten Gesamtlaufzeit wird ein zweiter Abstand des Ortes des Kurzschlusses ermittelt,
   - ein Unterschied zwischen dem ersten und dem zweiten Abstand wird ermittelt und
   - bei Vorliegen eines Unterschiedes wird auf einen Kurzschluß mit Lichtbogen erkannt.

4. Verfahren nach Anspruch 3,
   **gekennzeichnet durch**
   folgenden Schritt:

   - mit dem ersten und dem zweiten Abstand wird ein Leitungsabschnitt ermittelt, in dem sich der Kurzschluß bewegt hat.

5. Verfahren nach Anspruch 1,
   **gekennzeichnet durch**
   folgende Schritte

   - als erstes Funksignal (13) wird ein erster Funkimpuls verwendet,
   - der am Ort (14) des Kurzschlusses (12) reflektierte erste Funkimpuls wird als erstes Störungssignal empfangen,
   - als ein zweites Funksignal wird danach ein zweiter Funkimpuls verwendet,
   - der in die Energieübertragungsleitung gesendet wird,
   - der am Ort (14) des Kurzschlusses (12) reflektierte zweite Funkimpuls wird als zweites Störungssignal empfangen
   - eine erste Störungssignalphase des ersten Störungssignals zum ersten Funkimpuls wird ermittelt,
   - eine zweite Störungssignalphase des zweiten Störungssignals zum zweiten Funkimpuls wird ermittelt und
   - bei Vorliegen eines Unterschiedes zwischen der ersten Störungssignalphase und der zweiten Störungssignalphase wird auf einen Kurzschluß mit Lichtbogen erkannt.

6. Verfahren nach Anspruch 5,
   **dadurch gekennzeichnet,** daß
   mit dem Unterschied zwischen der ersten Störungssignalphase und der zweiten Störungssignalphase ein Leitungsabschnitt ermittelt wird, in dem sich der Lichtbogen bewegt hat.

7. Verfahren nach Anspruch 5 oder 6,
   **dadurch gekennzeichnet,** daß
   der erste Funkimpuls und der zweite Funkimpuls durch Tastung eines periodischen Trägersignals gewonnen werden.

8. Verfahren nach einem der vorhergehenden Ansprüche,
   **dadurch gekennzeichnet,** daß
   das Funksignal bzw. die Funksignale so bandbegrenztes sind, daß nur ein Grundmode (TEM) der Energieübertragungsleitung (1) angeregt wird.

9. Verfahren nach Anspruch 8,
   **dadurch gekennzeichnet,** daß
   das Funksignal oder die Funksignale jeweils eine im wesentlichen gaußförmige Pulsform aufweist bzw. aufweisen.

10. Verfahren nach einem der vorhergehenden Ansprüche,
    **dadurch gekennzeichnet,** daß
    die Funksignale mit einem zeitlichen Abstand nacheinander gesendet werden, der größer ist als das Verhältnis von der zweifachen Länge der Energieübertragungsleitung zur Ausbreitungsgeschwindigkeit des Funksignals (13) in der Energieübertragungsleitung.

11. Verfahren nach einem der Ansprüche 2 bis 6,
    **dadurch gekennzeichnet** daß
    von der Auswerteeinrichtung (11) bei Vorliegen

    - eines Frequenzunterschieds zwischen dem ersten Störungssignal und dem ersten Funksignal oder
    - eines Unterschieds zwischen dem ersten Abstand und dem zweiten Abstand oder
    - eines Unterschieds zwischen der ersten Störungssignalphase und der zweiten Störungssignalphase

    ein einen Kurzschluß mit Lichtbogen anzeigendes Kennsignal gebildet wird.

12. Verfahren nach einem der vorhergehenden Ansprüche,
    **dadurch gekennzeichnet,** daß

gleichzeitig eine Kurzschlußmessung durchgeführt und im Störungsfall eine Energiezufuhr zur Energieübertragungsleitung (1) unterbrochen wird.

13. Verfahren nach einem der vorhergehenden Ansprüche,
**dadurch gekennzeichnet,** daß
mit dem Funksignal (13) ein in der Energieübertragungsleitung angeordneter drahtlos abtragbarer Sensor abgefragt wird.

FIG 1

FIG 2

FIG 3

FIG 4